**Europäisches Patentamt**

**European Patent Office**

**Office européen des brevets**

(19)

(11) Numéro de publication : **0 438 340 B1**

## (12) FASCICULE DE BREVET EUROPEEN

(45) Date de publication du fascicule du brevet :
**20.09.95 Bulletin 95/38**

(51) Int. Cl.⁶ : **H03M 7/30**

(21) Numéro de dépôt : **91400067.4**

(22) Date de dépôt : **14.01.91**

(54) **Procédé et appareil de compression de données.**

(30) Priorité : **15.01.90 FR 9000394**

(43) Date de publication de la demande :
**24.07.91 Bulletin 91/30**

(45) Mention de la délivrance du brevet :
**20.09.95 Bulletin 95/38**

(84) Etats contractants désignés :
**DE GB**

(56) Documents cités :
**IEEE TRANSACTIONS ON INFORMATION THEORY, vol. IT-26, no. 1, janvier 1980, pages 15-25; M. GUAZZO: "A general minimum-redundancy source-coding algorithm"**

(73) Titulaire : **FRANCE TELECOM**
**6, Place d'Alleray**
**F-75015 Paris (FR)**

(72) Inventeur : **Battail, Gérard**
**9 Place de Rungis**
**F-75013 Paris (FR)**

(74) Mandataire : **Martinet & Lapoux**
**BP 405**
**F-78055 St. Quentin en Yvelines Cédex (FR)**

EP 0 438 340 B1

# EP 0 438 340 B1

## Description

La présente invention concerne un procédé de compression de données adaptatif.

L'expression "compression de données" signifie ici un moyen de remplacer un message numérique par un message aussi bref que possible à partir duquel le message initial peut être exactement restitué. L'opération de transformation du message originel est dite codage de source, au sens de la théorie de l'information, et la transformation inverse qui opère la restitution de ce message, décodage.

Le procédé est adaptatif en ce sens qu'il n'exige pas la connaissance statistique préalable de la source du message à coder. Il existe en effet de nombreuses situations pratiques où cette connaissance est partielle ou même absente. Par exemple, un fichier de données ne correspond en général à aucune structure statistique connue a priori.

Le procédé selon l'invention est du type de celui décrit par GUAZZO dans l'article "A General Minimum-Redundancy Source-Coding Algorithm" paru dans les IEEE Transactions on Information Theory, volume IT-26, numéro 1, janvier 1980, pages 15 à 25, pour une source dont les probabilités sont connues et stationnaires.

L'invention vise à rendre l'algorithme d'un tel procédé à la fois adaptatif et aisément réalisable. Les seules opérations qui doivent être effectuées sont des additions, des comparaisons ou des décalages, le résultat de toutes les autres s'obtenant par la lecture de tables.

A cette fin, un procédé de compression de données

où des symboles d'une source d'origine à coder sont remplacés chacun par une suite d'éléments binaires déduite de leur représentation par un arbre binaire aux extrémités duquel sont associés lesdits symboles de la source,

lesdits éléments binaires sont interprétés pour les uns à un premier état logique, comme un ordre d'aller à gauche, et pour les autres à un second état logique comme un ordre d'aller à droite,

ladite suite indique le cheminement qui doit être suivi depuis l'origine de l'arbre pour atteindre celle des extrémités de l'arbre qui correspond audit symbole de la source,

la suite des éléments binaires ainsi associée à une suite des symboles émis par la source d'origine, qui lui est équivalente, est interprétée comme engendrée par une source binaire auxiliaire,

un codage de chacun des éléments de ladite source binaire auxiliaire consiste, un nombre entier déterminé m de suites étant disponible pour le codage, à partager l'ensemble de ces suites disponibles de telle sorte que la transmission de l'une quelconque de $m_0$ premières suites représente un élément au premier état tandis que la transmission de l'une quelconque des $m_1 = m - m_0$ séquences restantes représente un élément au second état,

$m_0$ est un entier choisi tel que le rapport $m_0/m$ constitue une approximation satisfaisante, au sens d'un critère d'approximation prédéterminé, d'une estimation disponible p de la probabilité de l'élément au premier état conditionnellement au noeud atteint dans l'arbre,

une suite codée provisoire est désignée par le plus petit nombre des suites de l'ensemble auquel elle appartient, soit 0 pour l'élément au premier état et $m_0$ pour l'élément au second état, et

le nombre total m des suites disponibles pour le codage d'un élément binaire suivant devient $s2^n$, où s désigne la provision de suites disponibles pour continuer le codage, soit $s = m_0$ si l'élément binaire précédent est au premier état, $s = m_1$ si l'élément binaire précédent est au second état, n étant un entier choisi pour que le critère d'approximation pour ledit codage puisse être satisfait,

le numéro de la suite provisoire désigné par le codage est ajouté au résultat provisoire précédent préalablement multiplié par $2^n$,

est caractérisé en ce que

chaque noeud de l'arbre est associé à deux compteurs initialisés à 1 et comptant respectivement les éléments aux premier et second états de la source auxiliaire associée à l'arbre, lesdits éléments binaires concernant des branches d'arbre issues de ce noeud,

quand l'un quelconque desdits deux compteurs associé à un noeud atteint une taille maximale, les contenus de l'un et de l'autre compteurs sont réduits en les divisant par un même facteur, à une approximation entière près, et

$p = c_0/(c_0 + c_1)$ désigne l'estimation courante de la probabilité de l'élément au premier état de la source auxiliaire, conditionnellement au fait que le noeud correspondant est atteint.

D'autres avantages et caractéristiques de la présente invention apparaîtront plus clairement à la lecture de la description suivante en référence aux dessins annexés dans lesquels :

- la Fig. 1 est un diagramme montrant un arbre binaire à trois noeuds et quatre feuilles;
- la Fig. 2 est un diagramme analogue à celui de la Fig. 1, dit diagramme des transitions, dans lequel les feuilles sont fusionnées avec la racine de l'arbre;
- la Fig. 3 représente un algorithme de codage-décodage, et particulièrement du traitement d'un noeud

2

d'arbre, pour le procédé de compression de données selon l'invention;

- la Fig. 4 est un bloc-diagramme schématique d'une réalisation préférée d'un codeur mettant en oeuvre le procédé selon l'invention; et
- la Fig. 5 est un bloc-diagramme d'un circuit de mémorisation de nombres de branches comptés en un noeud, inclus dans le codeur de la Fig. 4.

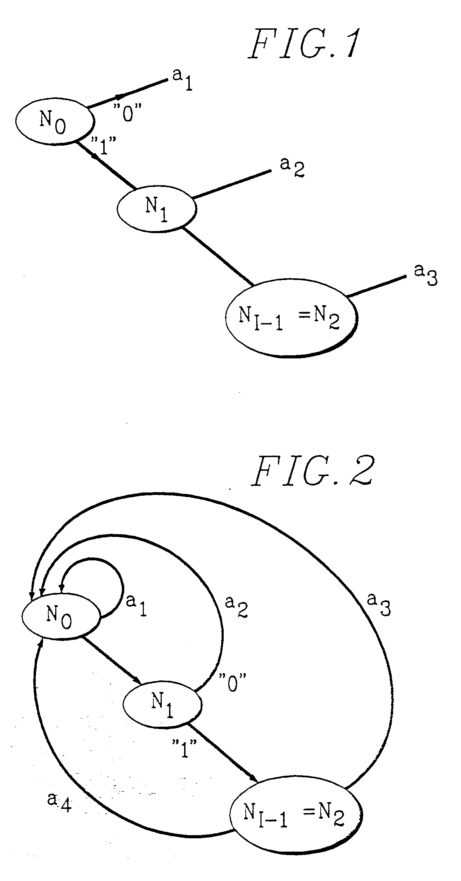

Le procédé selon l'invention comporte, comme celui décrit par GUAZZO, une description d'un message à coder à l'aide d'un arbre binaire. Quel que soit l'alphabet de la source primaire transmettant ce message, les symboles de la source sont représentés par l'indication du cheminement qui doit être parcouru dans l'arbre binaire, de l'origine $N_0$, dite également racine, à l'une quelconque des extrémités de l'arbre, appelées feuilles. Chaque feuille est associée à l'un respectif des symboles de l'alphabet de la source. La Fig. 1 montre un tel arbre binaire pour une source quaternaire dont les symboles primaires sont notés $a_1$, $a_2$, $a_3$ et $a_4$. On conviendra que l'indication "prendre la branche de gauche"est associée à l'élément binaire $b = "0"$ à un premier état logique, et l'indication "prendre la branche de droite" à l'élément binaire $b = "1"$ à un second état logique.

En outre, la représentation par l'arbre est transformée en faisant fusionner les feuilles avec la racine, l'indication du symbole $a_1$ à $a_4$ de la source étant portée par chacune des branches qui mène à la racine $N_0$, conformément à la Fig. 2. Le diagramme ainsi obtenu est dit diagramme des transitions. Alors, le message transmis par la source est entièrement équivalent à la suite des ordres "aller à gauche" ou "aller à droite"qui décrit dans ce diagramme le cheminement correspondant à la succession des symboles de ce message. La représentation binaire de la suite de ces ordres constitue une source auxiliaire, dite également source secondaire équivalente à la source d'origine.

D'autre part, en chacun des $I = 3$ noeuds $N_0$ à $N_{I-1} = N_2$ de l'arbre, la représentation des éléments binaires "0" et "1" consiste à partager en deux parties un certain ensemble de suites binaires disponibles, appelées "sequences" selon GUAZZO. Le nombre entier de ces suites binaires pour ce noeud courant $N_i$ est noté m, où l'indice i est compris entre 0 et I-1. L'appartenance aux $m_0$ premières de ces m suites, numérotées de 0 à $m_0$ -1, sert à désigner le symbole "0" de la source auxiliaire, tandis que l'appartenance aux $m_1 = m-m_0$ suites restantes, numérotées de $m_0$ à m-1 désigne l'élément "1" de la source auxiliaire.

On montre que la représentation du message binaire de la source auxiliaire atteint la concision maximale si, et seulement si, en chacun des noeuds de l'arbre, il y a égalité entre

- le rapport $m_0/m$ du nombre des suites disponibles pour représenter l'élément binaire "0" au nombre total des suites disponibles, et
- la probabilité que le chemin passe par la branche associée à cet élément binaire, soit la branche de gauche, conditionnellement au fait que ce noeud est atteint.

Une bonne approximation de la concision optimale est obtenue si ce rapport $m_0/m$ est voisin de cette probabilité p au sens d'un critère prédéterminé d'approximation qui garantit une performance minimale.

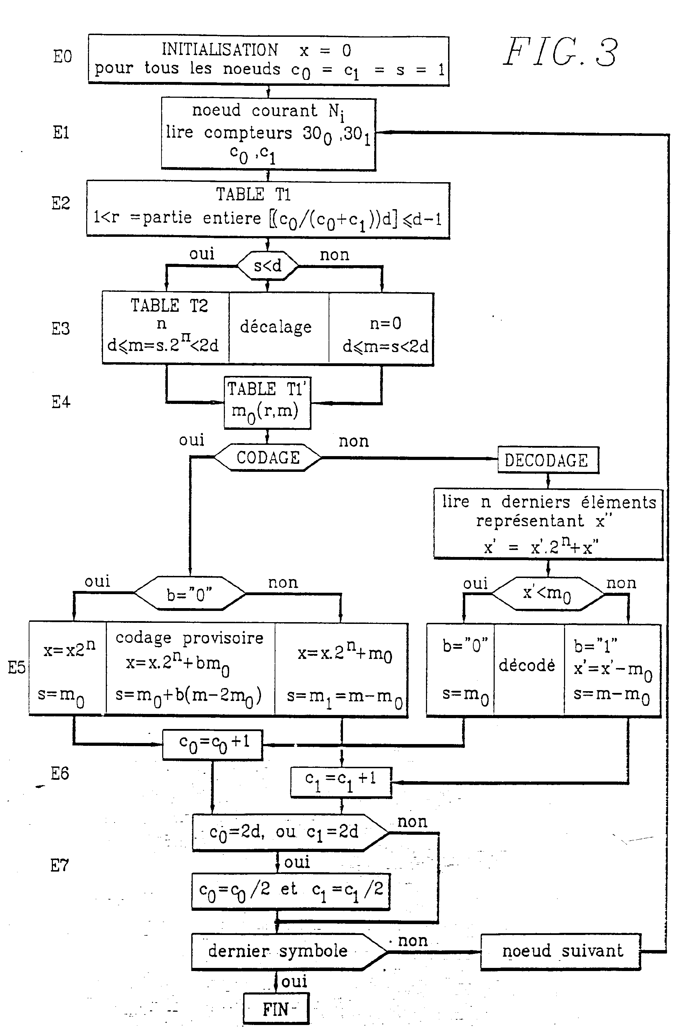

Référence est maintenant faite à l'algorithme de la Fig. 3 pour décrire en détail les diverses étapes de calcul du résultat provisoire du codage d'un symbole primaire correspondant à un noeud courant de l'arbre.

En chacun des noeuds du diagramme des transitions de la Fig. 2, appelé noeud courant, les probabilités conditionnelles des éléments "0" et "1" sont déterminées par une paire de compteurs dont l'un compte les éléments "0" et l'autre les éléments "1". En désignant par $c_0$ et $c_1$ les contenus respectifs de ces compteurs, $p = c_0/(c_0 + c_1)$ constitue une estimation de la probabilité conditionnelle de l'élément "0" au noeud courant.

On assure à la fois le maintien d'une taille finie des compteurs et l'adaptation à une variation des probabilités en réduisant simultanément d'un même facteur f, supposé dans toute la suite égal à 2, les contenus des deux compteurs associés à un noeud lorsqu'un seul des deux compteurs atteint une valeur entière prédéterminée 2d. A une étape d'initialisation E0 du codage du message, le contenu initial des compteurs doit au moins être égal à 1 pour éviter que l'estimation d'une probabilité soit égale à 0 ou à 1, ce qui empêcherait de continuer le codage. Selon la Fig. 3, les comptes sont initialement $c_0 = 1$ et $c_1 = 1$. Pour la même raison, la division par 2 d'un contenu impair de compteur doit s'entendre comme arrondie au plus proche entier par excès. Dans la suite, les compteurs sont supposés

ou bien tous de même taille, auquel cas leur taille maximale est égale à 2d, d étant leur contenu après la réduction qui en évite la saturation, comme indiqué à la dernière étape E7 de calcul pour le noeud courant dans la Fig. 3,

ou bien d'une taille qui décroît d'un facteur 1/2 par branche en fonction de la profondeur dans l'arbre, 2d étant alors la taille maximale des compteurs associés à l'origine $N_0$ de l'arbre et, plus généralement, $(d/2^{i-1})$ étant la taille maximale pour un noeud $N_i$ que i branches séparent de l'origine $N_0$, l'indice i étant un entier compris entre 0 et I-1.

On se donne un nombre initial de suites binaires qui, si l'alphabet utilisé pour le codage est binaire, ce qui a été supposé jusqu'ici, est de la forme $m = 2^n$, où n est un entier tel que l'on puisse trouver un nombre entier $m_0$ pour lequel $m_0/m$ est une approximation de p satisfaisant audit critère prédéterminé pour le noeud initial

$N_0$ du diagramme des transitions. On désigne les suites binaires codées par un nombre x de 0 à m-1, pris provisoirement égal à 0 si le premier élément binaire de la source auxiliaire est "0", et égal à $m_0$ si ce premier élément binaire est "1" (étape E5 pour $N_0$). On dispose alors, pour poursuivre le codage, d'une provision de s suites binaires possibles, avec s = $m_0$ si le premier élément binaire au noeud $N_0$ est "0", et s = $m_1$ = m-$m_0$ si ce premier élément est "1". Au second noeud $N_1$ du chemin parcouru dans le diagramme des transitions, le nombre total de suites binaires disponibles est m = s $2^n$, où n est un entier déterminé selon le même critère que précédemment, et p désigne maintenant la probabilité conditionnelle de "0" au noeud de $N_1$. Il correspond à cette probabilité une nouvelle valeur de $m_0$ (étapes E3, E4). Le codage provisoire a pour résultat $x2^n$ si l'élément choisi au deuxième noeud est "0", et $(x2^n)$ + $m_0$ si l'élément choisi est "1", où x désigne le résultat du codage provisoire pour le noeud précédant le noeud courant $N_1$, en l'occurrence x = $m_0$ pour le noeud $N_0$ (étape E5). Ce processus des étapes E1 à E7 est répété à tous les noeuds rencontrés lors du cheminement dans le diagramme des transitions spécifié par le message.

L'approximation des probabilités estimées p est réalisée sous la forme rationnelle r/d, où l'entier d a été défini ci-dessus et où r est un entier quelconque de 1 à d-1, cette condition définissant ledit critère prédéterminé d'approximation. Les performances de l'algorithme selon l'invention, qui dépendent seulement de la précision de l'approximation de la probabilité, sont donc exclusivement fonction du paramètre d. Ce paramètre détermine à la fois la précision avec laquelle la probabilité est estimée dans un contexte stationnaire, et la précision de l'approximation de cette probabilité par $m_0$/m.

Par ailleurs, le nombre respectif n des éléments binaires qui doivent être ajoutés à chaque noeud et qui résulte du facteur multiplicatif $2^n$ du résultat de codage provisoire précédent x, est choisi tel que l'on ait d $\leqq$ m <2d.

Deux tables à double entrée T1 et T1' sont avantageusement employées pour les opérations suivantes :
a) Table T1: détermination du nombre r qui définit l'approximation de la probabilité conditionnelle en fonction des contenus $c_0$ et $c_1$ des compteurs associés à chacun des noeuds :

1 $\leqq$ r = partie entière $[(c_0/(c_0 + c_1))d]$ à $\pm$ 0,5 près $\leqq$ (d - 1) ;

b) Table T1': détermination du nombre $m_0$ associé à un nombre m donné, tel que $m_0$/m soit une approximation satisfaisante de p. C'est simplement la valeur de $c_0$ dans cette table telle que, pour les entrées $c_0$ et $c_1$ = m-$m_0$, on y lise le nombre r associé à p.

Le résultat de l'opération a) est obtenu par lecture directe dans la table T1 (Etape E2), dont un exemple est donné ci-dessous pour d=8. Pour le résultat de l'opération b), la double inégalité satisfaite par m, savoir d $\leqq$ m <2d, entraîne qu'il existe au moins une valeur égale à r dans la table T1, mais il peut en exister deux. Pour éviter toute ambiguïté, le plus simple est de réarranger la table de telle sorte qu'elle donne une valeur de $m_0$ en fonction de r associé à p et de m, pour les valeurs pouvant être prises par le paramètre m, c'est-à-dire comprises entre d et 2d - 1. Un exemple de cette table T1' est aussi donné ci-dessous.

Préalablement à l'opération b), une table auxiliaire T2 est avantageusement employée pour déterminer les valeurs de n et donc les valeurs de m en fonction de la provision disponible s si celle-ci est inférieure à d, soit s<d et d $\leqq$ m = s.$2^n$<2d. Un exemple de la table T2 est donné ci-après, toujours pour d = 8.

TABLE 1

| | | | | | | | | $c_0$ | | | | | | | | |
|---|---|---|---|---|---|---|---|---|---|---|---|---|---|---|---|---|
| | | 1 | 2 | 3 | 4 | 5 | 6 | 7 | 8 | 9 | 10 | 11 | 12 | 13 | 14 | 15 |
| | 1 | 4 | 5 | 6 | 6 | 7 | 7 | 7 | 7 | 7 | 7 | 7 | 7 | 7 | 7 | 7 |
| | 2 | 3 | 4 | 5 | 5 | 6 | 6 | 6 | 6 | 7 | 7 | 7 | 7 | 7 | 7 | 7 |
| | 3 | 2 | 3 | 4 | 5 | 5 | 5 | 6 | 6 | 6 | 6 | 6 | 6 | 6 | 7 | 7 |
| | 4 | 2 | 3 | 3 | 4 | 4 | 5 | 5 | 5 | 6 | 6 | 6 | 6 | 6 | 6 | 6 |
| | 5 | 1 | 2 | 3 | 4 | 4 | 4 | 5 | 5 | 5 | 5 | 5 | 6 | 6 | 6 | 6 |
| | 6 | 1 | 2 | 3 | 3 | 4 | 4 | 4 | 5 | 5 | 5 | 5 | 5 | 5 | 6 | 6 |
| | 7 | 1 | 2 | 2 | 3 | 3 | 4 | 4 | 4 | 4 | 5 | 5 | 5 | 5 | 5 | 5 |
| $c_1$ | 8 | 1 | 2 | 2 | 3 | 3 | 3 | 4 | 4 | 4 | 4 | 5 | 5 | 5 | 5 | 5 |
| | 9 | 1 | 1 | 2 | 2 | 3 | 3 | 4 | 4 | 4 | 4 | 4 | 5 | 5 | 5 | 5 |
| | 10 | 1 | 1 | 2 | 2 | 3 | 3 | 3 | 4 | 4 | 4 | 4 | 4 | 5 | 5 | 5 |
| | 11 | 1 | 1 | 2 | 2 | 3 | 3 | 3 | 3 | 4 | 4 | 4 | 4 | 4 | 4 | 5 |
| | 12 | 1 | 1 | 2 | 2 | 2 | 3 | 3 | 3 | 3 | 4 | 4 | 4 | 4 | 4 | 4 |
| | 13 | 1 | 1 | 2 | 2 | 2 | 3 | 3 | 3 | 3 | 3 | 4 | 4 | 4 | 4 | 4 |
| | 14 | 1 | 1 | 1 | 2 | 2 | 2 | 3 | 3 | 3 | 3 | 4 | 4 | 4 | 4 | 4 |
| | 15 | 1 | 1 | 1 | 2 | 2 | 2 | 3 | 3 | 3 | 3 | 3 | 4 | 4 | 4 | 4 |

La table T1' donne les valeurs de $m_0$ en fonction de valeurs de r dans la première ligne et de valeurs de m dans la colonne de gauche.

TABLE T1'

| | 1 | 2 | 3 | 4 | 5 | 6 | 7 |
|---|---|---|---|---|---|---|---|
| 8 | 1 | 2 | 3 | 4 | 5 | 6 | 7 |
| 9 | 1 | 2 | 3 | 4 | 6 | 7 | 8 |
| 10 | 1 | 2 | 4 | 5 | 6 | 8 | 9 |
| 11 | 1 | 3 | 4 | 5 | 7 | 8 | 10 |
| 12 | 1 | 3 | 4 | 6 | 8 | 9 | 11 |
| 13 | 1 | 3 | 5 | 6 | 8 | 10 | 12 |
| 14 | 1 | 3 | 5 | 7 | 9 | 11 | 13 |
| 15 | 1 | 3 | 5 | 7 | 10 | 12 | 14 |

Dans la Table T2, la première ligne contient les valeurs de s, la deuxième celles de n et la troisième celles de m.

5

## TABLE T2

| s | 1 | 2 | 3 | 4 | 5 | 6 | 7 |
|---|---|---|---|---|---|---|---|
| n | 3 | 2 | 2 | 1 | 1 | 1 | 1 |
| m | 8 | 8 | 12 | 8 | 10 | 12 | 14 |

Le nombre engendré par l'algorithme de la Fig. 3 n'est limité que par la taille du message à coder. Il est souhaitable que la représentation binaire du message ne dépasse pas un nombre d'éléments binaires déterminé. A cette fin, la suite finie d'éléments binaires b composant le message transmis par la source auxiliaire est découpée régulièrement en des blocs ayant chacun N éléments binaires, où N est un entier prédéterminé. Chaque bloc est aisément déterminé en faisant la somme de tous les nombres de décalage n successivement calculés par l'algorithme de codage. Dès que cette somme dépasse le nombre N, le codage est interrompu, son résultat provisoire est complété à N chiffres par des "0" si c'est nécessaire, et est émis sous la forme d'un bloc. Le codage est réinitialisé, à l'exception des compteurs associés aux noeuds qui conservent leur contenu. Enfin le message utile est complété par autant de "0" que c'est nécessaire pour que le dernier bloc d'éléments codés émis soit de longueur N.

Le codage ainsi effectué n'est pas exactement irréductible en ce sens que la condition du préfixe n'est pas satisfaite, mais la connaissance des nombres m et $m_0$ à la première étape permet d'y déterminer l'élément "0" ou "1" puis, en retranchant $m_0$ du nombre reçu si ce symbole est égal à "1", l'opération peut être répétée au noeud suivant pour lequel les nouvelles valeurs de m et $m_0$ sont également connues, etc. Le code ainsi construit est donc déchiffrable.

Le décodage utilise la connaissance de l'arbre, de l'estimation des probabilités conditionnelles de ses branches et des règles d'application du critère qui sert à déterminer m. Comme on le verra dans la suite, pour tenir compte de l'adaptativité, le décodeur est muni des mêmes compteurs que le codeur et les fréquences des branches aux différents noeuds y sont déterminées de la même façon. Il est nécessaire que le message codé soit reçu dès son début et que la réactualisation des fréquences mesurées soit effectuée postérieurement au codage.

Dans la Fig. 3, à l'étape E5, le résultat provisoire du codage est désigné par x et le résultat définitif est donc x quand on atteint la fin de l'algorithme.

Par analogie pour le décodage, x' désigne le message codé reçu et transformé par le décodeur. Le message est lu par tranches de n éléments binaires, chacune représentant le nombre x''. On a supposé que les probabilités a priori de la source étaient inconnues. Le diagramme des transitions est déduit de l'arbre binaire naturel ou d'un autre arbre bien défini, par exemple l'arbre de Huffman pour les probabilités supposées.

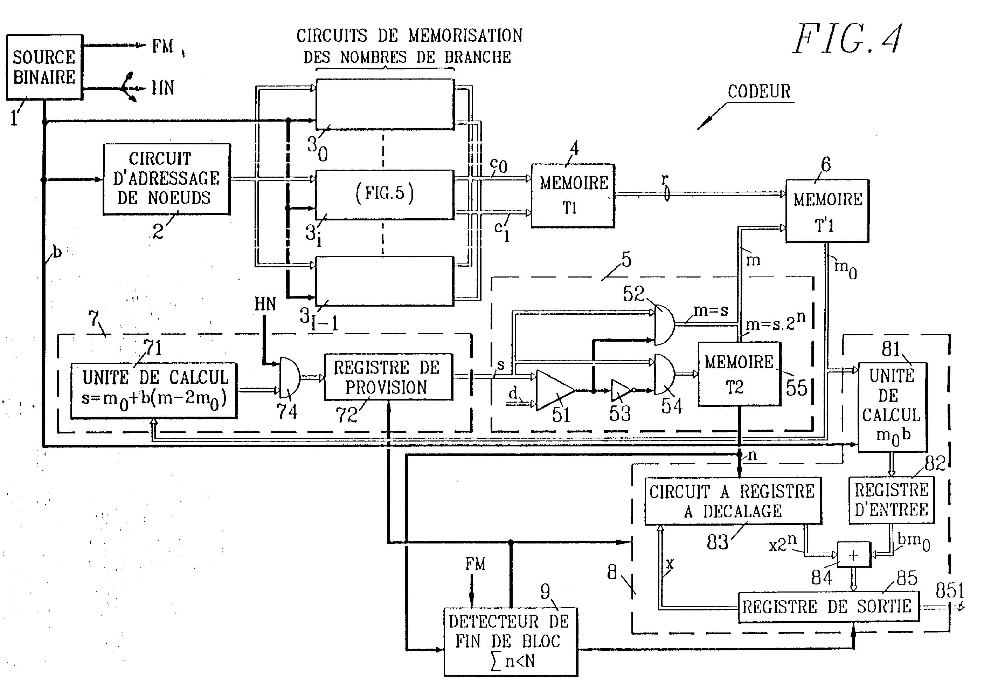

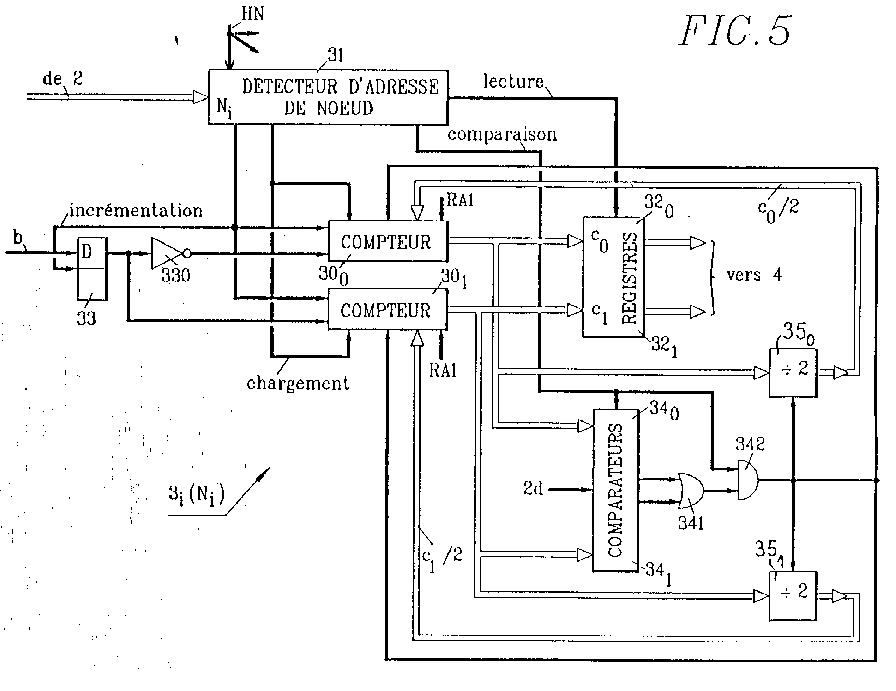

En référence maintenant à la Fig. 4, il est supposé qu'un codeur mettant en oeuvre le procédé selon l'invention fonctionne sur la base de l'arbre binaire naturel, c'est-à-dire dans lequel chacun des éléments de la représentation binaire d'un symbole primaire de la source peut être interprété comme indiquant en chaque noeud si le chemin qui conduit à la feuille associée à ce symbole passe par la branche de gauche ("0") ou de droite ("1"). L'origine ou racine $N_0$ de cet arbre correspond à l'élément de poids le plus fort de la représentation du symbole. La suite des éléments binaires correspondant ainsi aux symboles émis successivement par la source sera interprétée ci-après, comme transmise par une source binaire auxiliaire 1. Les éléments binaires b sont transmis par la source conjointement à divers signaux d'horloge, tels qu'un signal HN à la fréquence des bits ou éléments binaires entrants b, et donc du traitement des noeuds dans l'arbre, et un signal FM signalant la fin de chaque message. Le signal d'horloge HN est appliqué à tous les circuits 2 à 9 du codeur.

En entrée, le codeur comporte un circuit d'adressage de noeuds 2 pour traduire la progression dans l'arbre en fonction des éléments binaires de la source auxiliaire 1. Lorsqu'un noeud terminal ou feuille est atteint, il y a retour à la racine $N_0$. Ainsi, à chaque période du signal d'horloge HN, un noeud bien défini est atteint et est dit "noeud courant".

Le circuit d'adressage 2 transmet à travers un bus de sortie les adresses des noeuds qui sont progressivement traversés dans l'arbre binaire, à des circuits de mémorisation de nombres de branche $3_0$ à $3_{I-1}$ respectivement associés aux noeuds $N_0$ à $N_{I-1}$ de l'arbre. L'un, $3_i$, de ces circuits de mémorisation est détaillé dans la Fig. 5., l'indice i étant compris entre 0 et I-1.

Le circuit $3_i$ est structuré autour de deux compteurs $30_0$ et $30_1$ indiquant les comptes $c_0$ et $c_1$ associés au noeud $N_i$ et utilisés dans les étapes E1, E6 et E7 de l'algorithme selon la Fig. 3. Les compteurs servent à estimer la fréquence des éléments binaires qui indiquent la direction gauche ou droite à partir du noeud $N_i$. Les étapes E1, E6 et E7 sont commandées par un détecteur 31 détectant l'adresse du noeud $N_i$ qui est relié au bus d'adresse de sortie du circuit d'adressage 2 et qui joue le rôle de base de temps locale. Cette base de temps, ainsi que les autres circuits logiques inclus dans le circuit de mémorisation $3_i$ sont rythmés par le signal d'horloge HN.

Au début du traitement du noeud $N_i$ correspondant à l'étape E1, les comptes $c_0$ et $c_1$ sont lus respectivement dans deux registres de sortie $32_0$ et $32_1$ reliés à un double bus d'adressage d'une mémoire de table 4, comme on le verra dans la suite. Les comptes $c_0$ et $c_1$ sont ceux qui ont été calculés lors du traitement précédent du noeud $N_i$.

Puis une bascule d'entrée du type D 33 recevant l'élément binaire b est activée par le détecteur 31 afin de distinguer un élément binaire "1" d'un élément binaire "0". La sortie de la bascule 33 est reliée directement à une entrée de comptage du compteur $30_1$ et à travers un inverseur 330 à l'entrée de comptage du compteur $30_0$ de manière que les compteurs $30_0$ et $30_1$ soient incrémentés d'une unité en réponse à un élément binaire b="0", et à un élément binaire b="1", respectivement, comme indiqué à l'étape E6.

L'étape E7 est déclenchée par le détecteur 31, en activant deux comparateurs numériques $34_0$ et $34_1$. Les entrées de ces comparateurs ainsi que celles de deux diviseurs numériques par deux $35_0$ et $35_1$ sont respectivement reliées au bus de sortie des compteurs $30_0$ et $30_1$. Les comparateurs $34_0$ et $34_1$ comparent les comptes $c_0$ et $c_1$ calculés à l'étape E6 à la valeur maximale de $2d-1$, où d est le paramètre entier qui spécifie la précision de l'estimation des probabilités conditionnelles des branches en chaque noeud. Les sorties des comparateurs $34_0$ et $34_1$ commandent en commun des entrées d'activation des diviseurs $35_0$ et $35_1$ à travers une porte OU à deux entrées 341 et une porte ET à deux entrées 342 ouverte par le détecteur 31. Lorsque l'un des comptes $c_0$ et $c_1$ atteint la valeur 2d, l'un des comparateurs $34_0$ et $34_1$ applique un "1" aux entrées d'activation des diviseurs $35_0$ et $35_1$. Les résultats des divisions $c_0/2$ et $c_1/2$ sont chargés respectivement dans les compteurs $30_0$ et $30_1$ sous la commande du détecteur d'adresse 31 et de la sortie de la porte ET 342, à la fin de l'étape E7. Les divisions précédentes sont effectuées avec une approximation entière par excès.

Il est à noter qu'initialement, au début du traitement d'un message, les compteurs $30_0$ et $30_1$ sont mis à "1" (RA1) par la source 1, en correspondance avec l'étape E0.

En se reportant à nouveau à la Fig. 4, le codeur comporte trois mémoires 4, 5 et 6 pour mémoriser les tables T1, T2 et T1′ et pour effectuer les étapes E2 à E4, un premier circuit de calcul 7 pour calculer la provision s, et un second circuit de calcul 8 pour calculer le résultat de codage provisoire x.

A l'étape E2, les contenus des compteurs $30_0$ et $30_1$ associés au noeud courant $N_i$ et désignés respectivement par $c_0$ et $c_1$ servent d'adresses respectivement de colonne et de ligne de la première table T1 mémorisée dans la mémoire 4. En réponse à ces deux adresses, le nombre r, numérateur de la meilleure approximation rationnelle de $p = c_0/(c_0+c_1)$ ayant d pour dénominateur, est appliqué comme adresse de colonne dans la table T1′ mémorisée dans la mémoire 6.

Au début de l'étape E3, un registre-mémoire de provision 72 est lu afin de comparer la provision précédemment mémorisée s au seuil d dans la mémoire 5, qui est sous la forme d'un circuit programmable. Dans la mémoire programmable 5, un comparateur numérique 51 active un premier circuit ET 52 recevant la provision s afin que celle-ci constitue une adresse de ligne de la table T1′ dans la mémoire 6, lorsque le nombre s est supérieur à d. Dans le cas contraire, la sortie du comparateur 51 active, à travers un inverseur 53, un autre circuit ET 54 pour lire des nombres n et m correspondant dans une mémoire 55 contenant la table T2 en réponse, en tant qu'adresse de lecture, au nombre s dans le registre 72. Le nombre $m = s.2^n$ est appliqué, comme précédemment, en tant qu'adresse de ligne à la mémoire 6, et le nombre n lu dans la mémoire 55 est appliqué à un circuit à registre à décalage 83 inclus dans le circuit 8, et à un détecteur de fin de bloc 9. Après la détermination du nombre m, égal soit à s, soit à $s.2^n$, comme spécifié à l'étape E3, la table T1′ dans la mémoire 6 est lue en fonction des adresses de lecture de colonne et de ligne r et m afin d'appliquer le nombre correspondant $m_0$ avec l'élément binaire b à des unités de calcul 71 et 81 incluses respectivement dans les circuits 7 et 8.

Ainsi, après l'étape E4, les unités de calcul 71 et 81 calculent respectivement le nombre $s=m_0+b(m-2m_0)$ et le nombre $m_0b$, conformément à l'étape E5. La nouvelle valeur s délivrée par l'unité 71 est inscrite dans le registre 72 à travers un circuit d'écriture ET 73 rythmé par le signal d'horloge HN. La valeur $m_0b$ ainsi calculée est inscrite dans un registre-tampon d'entrée 82 d'un accumulateur inclus dans le circuit 8. Dans cet accumulateur, les sorties du registre 82 ainsi que celles du circuit à registre à décalage 83 sont respectivement reliées à un circuit d'addition 84 qui produit une somme $x.2^n+bm_0$ à enregistrer dans un registre-tampon de sortie 85 de l'accumulateur.

Au début de chaque cycle de noeud, le contenu x du registre 85 est transféré dans les premiers étages du registre à décalage 83. A la fin de l'étape E3, le nombre n, qui peut être égal à zéro lorsque s est supérieur à d, et qui est lu dans la mémoire 55, est chargé dans un circuit de commande de décalage de registre inclus dans le circuit 83 afin que le nombre x précédemment enregistré soit décalé vers la gauche d'un nombre d'étages de registre à décalage égal au nombre n, pour réaliser la multiplication relative à la puissance n, soit $x.2^n$.

EP 0 438 340 B1

Les n étages à droite dans le registre 83 correspondant aux bits de poids faible sont alors égal à "0". Le nouveau nombre x est lu dans le registre 83 simultanément au nombre $m_0 b$ lu dans le registre 82 afin de les additionner dans l'additionneur 84.

Le détecteur de fin de bloc 9 effectue les opérations décrites ci-dessous, après la présentation de la table T2. Le détecteur 9 additionne les nombres de décalage n transmis par la mémoire 55 lorsque s > d, et compare la somme de ces nombres n à l'entier prédéterminé N. Dès que cette somme excède N, le détecteur 9 commande des opérations de fin de bloc consistant à transférer le contenu du registre de sortie 85 de l'accumulateur dans un bus de sortie 851 du codeur. A chaque fin de bloc, les registres 82, 83 et 85 de l'accumulateur sont remis à zéro, simultanément avec la remise initiale à "1" du registre de provision 72. En réponse au signal de fin de message FM, le détecteur 9 complète le contenu du registre 85 avec des "0" et commande la transmission du dernier bloc du message ainsi constitué ayant N éléments. En fin de message FM, les compteurs $30_0$ et $30_1$ dans les circuits de mémorisation de nombres de branche $3_0$ à $3_{I-1}$ sont remis à "1" (RA1).

Selon d'autres variantes, le message est découpé en des blocs de longueur fixe, auxquels correspondent des nombres différents de symboles codés respectivement.

Le décodeur correspondant au codeur montré à la Fig. 4 offre une structure analogue. A la place de recevoir des éléments binaires b, le décodeur reçoit des éléments binaires du message x, qui sont lus par tranche de n éléments binaires, représentant respectivement des nombres $x''$.

Dans le décodeur, un registre d'entrée d'accumulateur est chargé initialement par le bloc reçu, et l'accumulateur fonctionne en soustracteur. Le contenu du registre d'entrée d'accumulateur est comparé au nombre $m_0$ décalé comme l'indique le nombre n délivré par la mémoire contenant la table T2. Si ce contenu est inférieur au nombre $m_0$, le symbole de la source auxiliaire est décodé avec la valeur b="0". Si ledit contenu est supérieur ou égal à $m_0$, le symbole décodé est b="1". Le nombre $m_0$ décalé en fonction de l'indication du registre de décalage cumulé est soustrait au contenu de l'accumulateur. Quand ce contenu devient nul, il y a détection de fin de bloc et l'accumulateur doit être rechargé par un nouveau bloc. Le registre de provision est remis à sa valeur initiale "1".


## Revendications

1.  Procédé de compression de données où
    des symboles (a) d'une source d'origine à coder sont remplacés chacun par une suite d'éléments binaires (b) déduite de leur représentation par un arbre binaire aux extrémités duquel sont associés lesdits symboles de la source,
    lesdits éléments binaires sont interprétés pour les uns ("0") à un premier état logique, comme un ordre d'aller à gauche, et pour les autres ("1") à un second état logique, comme un ordre d'aller à droite,
    ladite suite indique le cheminement qui doit être suivi depuis l'origine ($N_0$) de l'arbre pour atteindre celle des extrémités de l'arbre qui correspond audit symbole de la source,
    la suite des éléments binaires ainsi associée à une suite des symboles émis par la source d'origine, qui lui est équivalente, est interprétée comme engendrée par une source binaire auxiliaire,
    un codage de chacun des éléments de ladite source binaire auxiliaire consiste, un nombre entier déterminé m de suites étant disponible pour le codage, à partager l'ensemble de ces suites disponibles de telle sorte que la transmission de l'une quelconque de $m_0$ premières suites (0 à $m_0-1$) représente un élément au premier état ("0") tandis que la transmission de l'une quelconque des $m_1=m-m_0$ séquences restantes ($m_0$ à $m-1$) représente un élément au second état ("1"),
    $m_0$ est un entier choisi tel que le rapport $m_0/m$ constitue une approximation satisfaisante, au sens d'un critère d'approximation prédéterminé, d'une estimation disponible p de la probabilité de l'élément au premier état ("0") conditionnellement au noeud atteint dans l'arbre,
    une suite codée provisoire est désignée par le plus petit nombre des suites de l'ensemble auquel elle appartient, soit 0 pour l'élément au premier état ("0") et $m_0$ pour l'élément au second état ("1"), et
    le nombre total m des suites disponibles pour le codage d'un élément binaire suivant devient $s2^n$, où s désigne la provision de suites disponibles pour continuer le codage, soit $s=m_0$ si l'élément binaire précédent est au premier état ("0"), et $s=m_1$ si l'élément binaire précédent est au second état ("1"), n étant un entier choisi pour que le critère d'approximation pour ledit codage puisse être satisfait,
    le numéro (0 ou $m_0$) de la suite provisoire désigné par le codage est ajouté au résultat provisoire précédent (s) préalablement multiplié par $2^n$
    caractérisé en ce que
    chaque noeud ($N_0$ à $N_{I-1}$) de l'arbre est associé à deux compteurs ($30_0$, $30_1$) initialisés à 1 et comptant respectivement les éléments aux premier et second états ("0", "1") de la source auxiliaire as-

8

sociée à l'arbre, lesdits éléments binaires concernant des branches d'arbre issues de ce noeud,

quand l'un quelconque desdits deux compteurs associé à un noeud atteint une taille maximale (2d), les contenus $c_0$, $c_1$ de l'un et de l'autre compteurs sont réduits en les divisant par un même facteur (f), à une approximation entière près, et

$p = c_0/(c_0+c_1)$ désigne l'estimation courante de la probabilité de l'élément au premier état ("0") de la source auxiliaire, conditionnellement au fait que le noeud correspondant est atteint.

2. Procédé selon la revendication 1, caractérisé par un facteur de réduction (f) des contenus $c_0$, $c_1$ des compteurs ($30_0$, $30_1$) égal à deux et une approximation entière correspondante par excès.

3. Procédé selon la revendication 2, caractérisé en ce que la taille 2d des compteurs ($30_0$, $30_1$) est la même pour tous les noeuds ($N_0$ à $N_{l-1}$) de l'arbre, d étant un nombre entier.

4. Procédé selon la revendication 2, caractérisé en ce que les deux compteurs ($30_0$, $30_1$) associés à l'origine ($N_0$) de l'arbre ont une taille égale à 2d, où d est un nombre entier, et les deux compteurs ($30_0$, $30_1$) associés à un noeud ($N_i$) que i branches de l'arbre séparent de l'origine ($N_0$) ont une taille égale à $d/2^{i-1}$, où i est un nombre entier.

5. Procédé selon la revendication 3 ou 4, caractérisé en ce que l'approximation de p est la fraction la plus proche de p de la forme r/d, où r est un entier quelconque de 1 à d-1 et où d est la valeur entière prise par l'un des compteurs ($30_0$, $30_1$) associés à l'origine de l'arbre ($N_0$), après la réduction qui en évite la saturation quand le contenu du compteur a atteint la taille maximale 2d.

6. Procédé selon la revendication 5, caractérisé en ce que les valeurs de r sont lues dans une table (T1) à double entrée en fonction des contenus $c_0$ et $c_1$ des compteurs ($30_0$, $30_1$).

7. Procédé selon les revendications 5 ou 6, caractérisé par la détermination de l'entier n tel que $m=2^n$ s soit le plus petit entier supérieur ou égal à d, s étant la provision de suites constituée antérieurement.

8. Procédé selon la revendication 7, caractérisé en ce que les valeurs de $m_0$ sont lues dans une table (T1') en fonction des nombres r et m.


**Patentansprüche**

1. Verfahren zur Datenkompression, in welchem
Symbole (a) einer zu codierenden Urquelle je durch eine Folge von Binärelementen (b) ersetzt werden, welche Folge aus deren Darstellung mittels eines Binärbaums entnommen wird, mit dessen Extremitäten die besagten Symbole der Quelle verknüpft werden,
besagte Binärelemente für die einen ("0") in einem ersten logischen Zustand als ein Befehl nach links interpretiert werden, und für die anderen ("1") in einem zweiten logischen Zustand als ein Befehl nach rechts,
besagte Folge den Verlauf zeigt, der vom Anfang ($N_0$) des Baumes gefolgt werden soll, um den Anfang der Extremitäten des Baumes zu erreichen, der dem besagten Symbol der Quelle entspricht,
die mit einer ihr äquivalenten Folge von durch die Urquelle gesendeten Symbolen derart verknüpfte Folge von Binärelementen interpretiert wird, als wäre sie durch eine Hilfsbinärquelle erzeugt,
eine Codierung der jeweiligen Elemente der besagten Hilfsbinärquelle darin besteht - dabei ist eine bestimmte Ganzzahl m von Folgen für die Codierung verfügbar - die Gruppe dieser verfügbaren Folgen derart aufzuteilen, daß die Übertragung irgendeiner der $m_0$ ersten Folgen (0 bis $m_0$ - 1) ein Element im ersten Zustand ("0") darstellt, während die Übertragung irgendeiner der $m_1 = m-m_0$ restlichen Folgen ($m_0$ bis m-1) ein Element im zweiten Zustand ("1") darstellt,
$m_0$ eine derart gewählte Ganzzahl ist, daß das Verhältnis $m_0/m$ eine befriedigende Approximation bildet - im Sinne eines vorbestimmten Approximationskriteriums - einer verfügbaren Schätzung p der Wahrscheinlichkeit des Elements im ersten Zustand ("0") bedingt durch den im Baum erreichten Knoten,
eine codierte provisorische Folge durch die kleinste Zahl von Folgen der Gruppe bezeichnet wird, zu welcher sie gehört, d.h. 0 für das Element im ersten Zustand ("0") und $m_0$ für das Element im zweiten Zustand ("1"), und
die Gesamtzahl m der verfügbaren Folgen für die Codierung eines folgenden Binärelements $s2^n$ wird, wo-

bei s der Vorrat an zur Fortführung der Codierung verfügbaren Folgen ist, d.h. $s=m_0$, wenn das vorige Binärelement im ersten Zustand ("0") ist, $s=m_1$, wenn das vorige Binärelement im zweiten Zustand ("1") ist, wobei n eine derart gewählte Ganzzahl ist, daß das Approximationskriterium für die besagte Codierung erfüllt werden kann,

die durch die Codierung bezeichnete Nummer (0 oder $m_0$) der provisorischen Folge mit dem provisorischen vorigen Ergebnis (s) addiert wird, das vorher mit $2^n$ multipliziert wird,

dadurch gekennzeichnet, daß

jeder Knoten ($N_0$ bis $N_{I-1}$) des Baumes mit zwei auf 1 initialisierten Zählern ($30_0$, $30_I$) verknüpft wird, die jeweils die Elemente im ersten und zweiten Zustand ("0", "1") der mit dem Baum verknüpften Hilfsquelle zählen, wobei die besagten Binärelemente aus diesem Knoten entstehende Baumzweige betreffen,

wenn irgendeiner der beiden besagten mit einem Knoten verknüpften Zähler eine maximale Größe (2d) erreicht, die Inhalte $c_0$, $c_1$ des einen und des anderen Zählers um eine ganze Approximation reduziert werden, indem sie durch einen gleichen Faktor dividiert werden, und daß

$p = c_0/(c_0+c_1)$ die übliche Schätzung der Wahrscheinlichkeit des Elements im ersten Zustand ("0") der Hilfsquelle ist, bedingt durch die Tatsache, daß der entsprechende Knoten erreicht ist.

2.  Verfahren nach Anspruch 1, gekennzeichnet durch einen Reduktionsfaktor (f) der Inhalte $c_0$, $c_1$ der Zähler ($30_0$, $30_I$) gleich zwei und einer entsprechenden aufgerundeten ganzen Approximation.

3.  Verfahren nach Anspruch 2, dadurch gekennzeichnet, daß die Größe 2d der Zähler ($30_0$, $30_I$) die gleiche für alle Knoten ($N_0$ bis $N_{I-1}$) des Baumes ist, wobei d eine Ganzzahl ist.

4.  Verfahren nach Anspruch 2, dadurch gekennzeichnet, daß die mit dem Anfang ($N_0$) des Baumes verknüpften zwei Zähler ($30_0$, $30_I$) eine Größe gleich 2d haben, wobei d eine Ganzzahl ist, und die mit dem Knoten ($N_i$) verknüpften zwei Zähler ($30_0$, $30_I$), den i Baumzweige vom Anfang ($N_0$) trennen, eine Größe gleich $d/2^{i-1}$ haben, wobei i eine Ganzzahl ist.

5.  Verfahren nach Anspruch 3 oder 4, dadurch gekennzeichnet, daß die Approximation von p der nächste Bruchteil von p der Form r/d ist, wobei r irgendeine Ganzzahl von 1 bis d-1 ist und d der Ganzwert ist, der von dem einen der Zähler ($30_0$, $30_I$) genommen wird, die mit dem Anfang des Baumes ($N_0$) verknüpft sind, nach der Reduktion, die deren Sättigung verhindert, wenn der Zählerinhalt eine maximale Größe von 2d erreicht hat.

6.  Verfahren nach Anspruch 5, dadurch gekennzeichnet, daß die Werte von r in einer Tabelle (T1) mit doppelter Eingabe in Abhängigkeit von den Inhalten $c_0$ und $c_1$ der Zähler ($30_0$, $30_I$) gelesen werden.

7.  Verfahren nach den Ansprüchen 5 oder 6, gekennzeichnet durch die Bestimmung der Ganzzahl n, damit $m=2^n$ s der kleinste Ganzzahl ist, die größer oder gleich d ist, wobei s der Vorrat der davor gebildeten Folgen ist.

8.  Verfahren nach Anspruch 7, dadurch gekennzeichnet, daß die Werte von $m_0$ in einer Tabelle (T1') in Abhängigkeit von den Zahlen r und m gelesen werden.


## Claims

1.  Data compression method wherein

    symbols (a) of an original source to be encoded each are replaced by a sequence of binary elements (b) deduced from their representation by a binary tree at the ends of which are associated said symbols of the source,

    said binary elements are interpreted in a first logic state as an order to turn left for certain elements ("0") and in a second logic state as an order to turn right for other elements ("1"),

    said sequence indicates the routing to be followed from the origin ($N_0$) of the tree to reach that of the ends of the tree that corresponds to said symbol of the source,

    the sequence of the binary elements thus associated with a sequence of the symbols transmitted by the original source, which is equivalent to it, is interpreted as generated by an auxiliary binary source,

    an encoding of each of the elements of said auxiliary binary source consists, as a predetermined integer m of sequences being available for the encoding, in splitting the set of these available sequences in such a way that the transmission of any one of $m_0$ first sequences (0 to $m_0-1$) represents an element in the first state ("0") whereas the transmission of any one of the $m_1=m-m_0$ remaining sequences ($m_0$ to $m-1$) represents an element in the second state ("1"),

$m_0$ is a chosen integer such that the ratio $m_0/m$ constitutes a satisfactory approximation, in the sense of a predetermined approximation criterion, of an available estimation p of the probability of the element in the first state ("0") conditionally at the node reached in the tree,

a provisional encoded sequence is designated by the smallest number of the sequences in the set to which it belongs, i.e., 0 for the element in the first state ("0") and $m_0$ for the element in the second state ("1"), and

the total number m of the available sequences for the encoding of a subsequent binary element becomes $s2^n$, where s denotes the provision of available sequences for continuing the encoding, i.e., $s=m_0$ if the previous binary element is in the first state ("0"), and $s=m_1$ if the previous binary element is in the second state ("1"), n being an integer chosen for the approximation criterion in order for said encoding to be able to be satisfactory,

the number (0 or $m_0$) of the provisional sequence designated by the encoding is added to the previous provisional result (s) multiplied beforehand by $2^n$,

characterized in that

each node ($N_0$ to $N_{I-1}$) of the tree is associated with two counters ($30_0$, $30_1$) initiated at 1 and respectively counting the elements in the first and second states ("0", "1") from the auxiliary source associated with the tree, said binary elements concerning tree branchings stemming from this node,

when any one of said two counters associated with a node reaches a maximum size (2d), the contents $c_0$, $c_1$ of both counters are reduced by dividing them by a same factor (f), to within an integral approximation, and

$p = c_0/(c_0+c_1)$ designates the current estimation of the probability of the element in the first state ("0") of the auxiliary source, provided the corresponding node has been reached.

2. Method according to claim 1, characterized by a reduction factor (f) of the contents $c_0$, $c_1$ of the counters ($30_0$, $30_1$) equal to two and a corresponding rounded up integral approximation.

3. Method according to claim 2, characterized in that the size 2d of the counters ($30_0$, $30_1$) is the same for all the nodes ($N_0$ to $N_{I-1}$) of the tree, d being an integer.

4. Method according to claim 2, characterized in that the two counters ($30_0$, $30_1$) associated with the origin ($N_0$) of the tree are a size equal to 2d, where d is an integer, and the two counters ($30_0$, $30_1$) associated with a node ($N_i$) separated from the origin ($N_0$) by i branchings of the tree are a size equal to $d/2^{i-1}$, where i is an integer.

5. Method according to claim 3 or 4, characterized in that the approximation of p is the nearest fraction to p in the form r/d, where r is any integer from 1 to d-1 and where d is the integral value taken by one of the counters ($30_0$, $30_1$) associated with the origin of the tree ($N_0$), after the reduction which avoids it saturating when the content of the counter has reached the maximum size 2d.

6. Method according to claim 5, characterized in that the values of r are read in a two-entry table (T1) as a function of the contents $c_0$ and $c_1$ of the counters ($30_0$, $30_1$).

7. Method according to the claims 5 or 6, characterized by the determination of the integer n such that $m=2^n$ s is the smallest integer more than or equal to d, s being the provision of sequences previously constituted.

8. Method according to claim 7, characterized in that the values of $m_0$ are read in a table (T1′) as a function of the numbers r and m.

FIG.1

FIG.2

*FIG.3*

**E0** — INITIALISATION $x = 0$
pour tous les noeuds $c_0 = c_1 = s = 1$

**E1** — noeud courant $N_i$
lire compteurs $30_0$, $30_1$
$c_0$, $c_1$

**E2** — TABLE T1
$1 < r = $ partie entiere $[(c_0/(c_0+c_1))d] \leqslant d-1$

$s < d$ — oui / non

**E3** —
| TABLE T2 $n$ $d \leqslant m = s.2^n < 2d$ | décalage | $n=0$ $d \leqslant m = s < 2d$ |

**E4** — TABLE T1'
$m_0(r,m)$

CODAGE — oui / non

DECODAGE

lire n derniers éléments
représentant $x''$
$x' = x'.2^n + x''$

$b = "0"$ — oui / non

$x' < m_0$ — oui / non

**E5** —
| $x = x2^n$ $s = m_0$ | codage provisoire $x = x.2^n + bm_0$ $s = m_0 + b(m-2m_0)$ | $x = x.2^n + m_0$ $s = m_1 = m - m_0$ | $b = "0"$ $s = m_0$ | décodé | $b = "1"$ $x' = x' - m_0$ $s = m - m_0$ |

$c_0 = c_0 + 1$

**E6** — $c_1 = c_1 + 1$

**E7** — $c_0 = 2d$, ou $c_1 = 2d$ — non

oui

$c_0 = c_0/2$ et $c_1 = c_1/2$

dernier symbole — non — noeud suivant

oui

FIN

13

FIG.4

*FIG.5*

EP 0 438 340 B1